# EUROPEAN PATENT APPLICATION

(11) **EP 4 722 574 A1**
(43) Date of publication of application: **08.04.2026**
(21) Application number: 24814463.6
(22) Date of filing: 29.05.2024
(51) Int. Cl.: F16L 23/02

(54) **SEMICONDUCTOR PROCESS DEVICE**

(30) Priority: 30.05.2023 CN 202310628146
(71) Applicant: Beijing NAURA Microelectronics Equipment Co., Ltd., Beijing 100176 (CN)
(72) Inventor: HUANG, Rongbiao, Beijing 100176 (CN); YANG, Huiping, Beijing 100176 (CN); YANG, Shuai, Beijing 100176 (CN); LI, Lin, Beijing 100176 (CN); SONG, Xinfeng, Beijing 100176 (CN); GUAN, Xiaochen, Beijing 100176 (CN)
(74) Representative: LifeTech IP Spies & Behrndt Patentanwälte PartG mbB
(86) International application number: PCT/CN2024/095942
(87) International publication number: WO 2024/245266

(57) **Abstract**

There is provided a semiconductor process equipment, including a process chamber (100), a first connector (210), a second connector (220), and a connecting device (300), the first connector (210) is connected to the process chamber (100), the connecting device (300) includes a first clamping member (330), a second clamping member (340), and a connecting assembly (350), the first clamping member (330) is sleeved on the first connector (210), the second clamping member (340) is sleeved on the second connector (220), one of the first clamping member (330) and the second clamping member (340) is provided with a positioning column (331), the other of the first clamping member (330) and the second clamping member (340) is provided with a positioning hole (341), the positioning column (331) is in positioning fit with the positioning hole (341) to make a central axis of the first connector (210) coincide with a central axis of the second connector (220), a gap is provided between the first connector (210) and the second connector (220), and one end of the positioning column (331) penetrates through the positioning hole (341) to be connected to the connecting assembly (350) to enable clamping of the first connector (210) and the second connector (220). The present disclosure can solve a problem that contact can be easily caused in a mating process of a gas pipeline of an existing semiconductor process equipment.

## Description

### TECHNICAL FIELD

The present disclosure belongs to the field of semiconductor technology, and particularly relates to a semiconductor process equipment.

### BACKGROUND

In the semiconductor field, gas pipelines made of a quartz material are needed for transporting process gases due to factors such as temperatures, corrosiveness, and tightness of the process gases. The reliability of a connecting device for connecting a gas pipeline to a semiconductor process chamber directly affects a final process result, so that the connecting device is very important.

For the gas pipeline, a first connector and a second connector matched with each other using concave and convex surfaces are generally adopted for mating to ensure coaxial arrangement of the first connector and the second connector, and then the first connector and the second connector are connected and fixed with a connecting device formed by a flange clamp. However, contact between the concave and convex surfaces of the first connector and the second connector can be easily caused in the mating process, and debris produced by the contact may enter the process chamber along with the gases, which affects the process result and reduces product quality.

### SUMMARY

The embodiments of the present disclosure aim to provide a semiconductor process equipment, which can solve the problem that contact can be easily caused in the mating process of the gas pipeline of the existing semiconductor process equipment.

In order to solve the above technical problem, the present disclosure is implemented as follows.

The embodiments of the present disclosure provide a semiconductor process equipment, including a process chamber, a first connector, a second connector, and a connecting device, wherein the first connector is connected to the process chamber,
the connecting device includes a first clamping member and a second clamping member, and the first clamping member and the second clamping member are configured to clamp the first connector and the second connector to enable the first connector to be in sealing fit with the second connector to form a gas pipeline; and
the first clamping member is sleeved on the first connector, the second clamping member is sleeved on the second connector, one of the first clamping member and the second clamping member is provided with a positioning column, the other of the first clamping member and the second clamping member is provided with a positioning hole, the positioning column is in positioning fit with the positioning hole to make a central axis of the first connector coincide with a central axis of the second connector, and a gap is provided between the first connector and the second connector.

In the embodiments of the present disclosure, one of the first clamping member and the second clamping member is provided with the positioning column, the other is provided with the positioning hole, the positioning column is in positioning fit with the positioning hole to make the central axis of the first connector coincide with the central axis of the second connector, and the gap is provided between concave and convex surfaces of the first connector and the second connector, so that contact between the concave and convex surfaces of the first connector and the second connector is avoided in a mating process of the gas pipeline. Therefore, the embodiments of the present disclosure can solve the problem that contact can be easily caused in the mating process of the gas pipeline of the existing semiconductor process equipment.

### BRIEF DESCRIPTION OF DRAWINGS

FIG. 1 is a schematic structural diagram of a connecting device according to an embodiment of the present disclosure;
FIG. 2 is a cross-section view of a connecting device according to an embodiment of the present disclosure;
FIG. 3 is an exploded view of a connecting device according to an embodiment of the present disclosure;
FIG. 4 is a sectional view of a connecting device according to an embodiment of the present disclosure;
FIG. 5 is a schematic structural diagram of a first clamping member, a second clamping member, and a connecting assembly according to an embodiment of the present disclosure;
FIG. 6 is an exploded view of a first clamping member, a second clamping member, and a connecting assembly according to an embodiment of the present disclosure;
FIG. 7 is a side view of a first clamping member and a second clamping member according to an embodiment of the present disclosure;
FIG. 8 is a schematic structural diagram of a first clamping member according to an embodiment of the present disclosure;
FIG. 9 is a partial enlarged view of a positioning column according to an embodiment of the present disclosure;
FIG. 10 is a schematic structural diagram of a second clamping member according to an embodiment of the present disclosure;
FIG. 11 is an exploded view of a first connector, a second connector, and a sealing ring according to an embodiment of the present disclosure;
FIG. 12 and FIG. 13 are sectional views of a first connector, a second connector, and a sealing ring in different states according to the embodiments of the present disclosure;
FIG. 14 is a top view of a first connector according to an embodiment of the present disclosure;
FIG. 15 is a sectional view of a connecting assembly according to an embodiment of the present disclosure; and
FIG. 16 is a schematic structural diagram of part of a semiconductor process equipment according to an embodiment of the present disclosure.

### Description of reference numerals:

100-process chamber;
210-first connector, 211-matching protrusion, 212-first flange part, 2121-first positioning plane, 220-second connector, 221-matching groove, 222-second flange part, 2221-second positioning plane, 230-sealing ring;
300-connecting device, 330-first clamping member, 331-positioning column, 3311-first positioning column, 3312-second positioning column, 3313-third positioning column, 3314-third positioning plane, 3315-positioning groove, 3316-positioning section, 3317-connecting section, 3318-smooth section, 3319-threaded connection section, 332-first avoidance opening, 340-second clamping member, 341-positioning hole, 342-second avoidance opening, 350-connecting assembly, 351-connecting sleeve, 3511-mounting groove, 352-locking member, 3521-elastic driving portion, 3522-positioning portion, 360-protection sleeve, 370-first buffer pad, 380-second buffer pad.

### DETAIL DESCRIPTION OF EMBODIMENTS

The technical solutions provided in the embodiments of the present disclosure are clearly and thoroughly described below with reference to the drawings for the embodiments of the present disclosure. Apparently, the embodiments described herein are just some embodiments of the present disclosure, and do not cover all embodiments. All other embodiments derived by those of ordinary skill in the art from the embodiments described herein without inventive work fall within the scope of the present disclosure.

The terms "first", "second" and the like in the description and the claims of the present disclosure are used for distinguishing between similar objects, but not for describing a particular order or a chronological order. It should be understood that the data such used may be interchanged under appropriate circumstances, so as to allow the embodiments of the present disclosure to be implemented in an order other than those illustrated or described herein; and the objects distinguished by the terms "first", "second" and the like generally belong to one kind, and the number of the objects is not limited, for example, the number of a first object may be one or more. In addition, the term "and/or" in the description and the claims indicates at least one of the objects connected by the term "and/or", and the forward slash "/" generally indicates that the object before "/" and the object after "/" are in an "or" relationship.

With reference to the drawings, the semiconductor process equipment provided in the embodiments of the present disclosure are described in detail below in conjunction with specific embodiments and application scenarios.

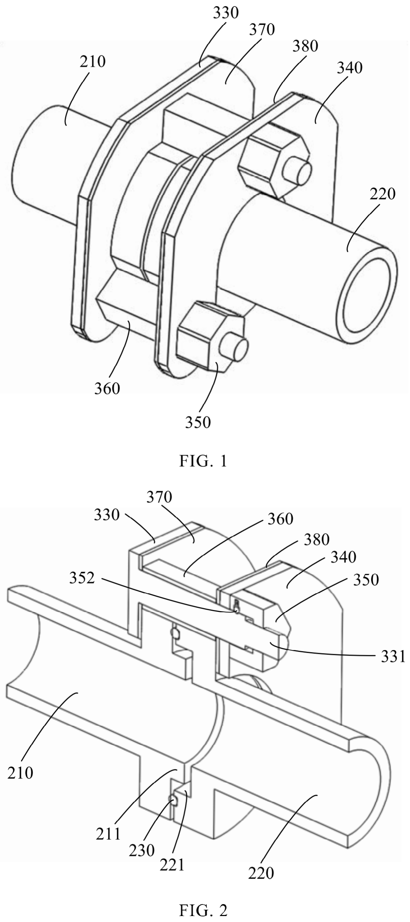

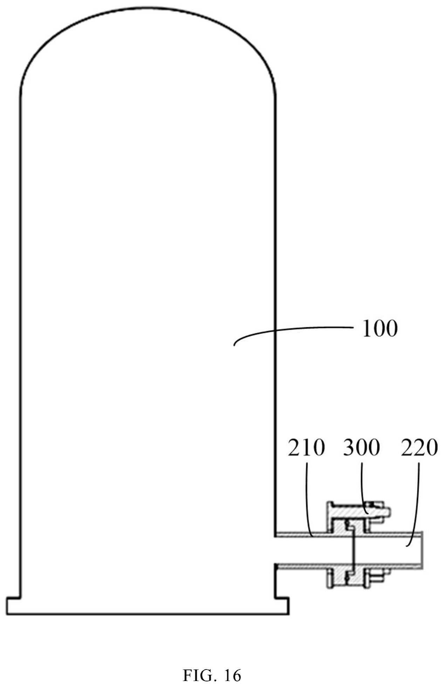

As shown in FIG. 1 to FIG. 16, the embodiments of the present disclosure provide a semiconductor process equipment, including a process chamber 100, a first connector 210, a second connector 220, and a connecting device 300, and the first connector 210 is connected to the process chamber 100. In some embodiments, the first connector 210 and the process chamber 100 may be a one-piece structure or separate structures, which is not particularly limited in the embodiments of the present disclosure, but sealing performance between the two structures needs to meet gas transportation requirements no matter the two structures adopt the one-piece structure or the separate structures. Further, in some embodiments, when the first connector 210 and the process chamber 100 are the separate structures, the first connector 210 and the process chamber 100 may be connected to each other, for example, by means of welding or with a threaded connector, and a sealing structure such as an O-ring is adopted to seal the first connector 210 and the process chamber 100, so as to ensure the sealing performance. In some embodiments, a connection between the first connector 210 and the process chamber 100 may be located in a lower part of the process chamber 100 (for example, at a position on a sidewall of the chamber close to a lower end), so as to reduce an influence on other structures. In some embodiments, the first connector 210 and the second connector 220 may be made of a quartz material. Certainly, the first connector 210 and the second connector 220 may also be made of other materials, which is not particularly limited herein. In an embodiment, the second connector 220 and other parts of a pipeline where the second connector 220 is located form a one-piece structure.

The connecting device 300 includes a first clamping member 330 and a second clamping member 340, and the first clamping member 330 and the second clamping member 340 are configured to clamp the first connector 210 and the second connector 220, so as to enable the first connector 210 to be in sealing fit with the second connector 220 to form a gas pipeline which is communicated with the process chamber 100. In some embodiments, the gas pipeline may be a gas inlet pipeline or an exhaust pipeline. Certainly, the gas pipeline may be other gas transportation pipelines such as a circulation pipeline, which is not particularly limited herein.

In some embodiments, the first clamping member 330 and the second clamping member 340 may be flange clamps. For example, the flange clamps are U-shaped plates. Certainly, the flange clamps may also be other plate-like structures, which is not particularly limited herein. Specifically, the first clamping member 330 is sleeved on the first connector 210, the second clamping member 340 is sleeved on the second connector 220, one of the first clamping member 330 and the second clamping member 340 is provided with a positioning column 331, the other of the first clamping member 330 and the second clamping member 340 is provided with a positioning hole 341, and the positioning column 331 is in positioning fit with the positioning hole 341, so as to make a central axis of the first connector 210 coincide with a central axis of the second connector 220. Moreover, a gap is provided between the first connector 210 and the second connector 220, so as ensure coaxial arrangement of the first connector 210 and the second connector 220 while avoiding contact between the first connector 210 and the second connector 220.

In some embodiments, the semiconductor process equipment further includes a sealing ring 230, which is disposed between the first connector 210 and the second connector 220, and the first connector 210 is in sealing fit with the second connector 220 through the sealing ring 230, so as to improve sealing performance of the gas pipeline. Further, in some embodiments, a surface of the second connector 220 facing the first connector 210 is provided with a groove, part of the sealing ring 230 is disposed in the groove, and the groove is configured to fix the sealing ring 230.

In the embodiments of the present disclosure, one of the first clamping member 330 and the second clamping member 340 is provided with the positioning column 331, and the other one is provided with the positioning hole 341, so that the central axis of the first connector 210 can coincide with the central axis of the second connector 220; with the gap provided between the concave and convex surfaces of the first connector 210 and the second connector 220, the contact between the concave and convex surfaces of the first connector 210 and the second connector 220 can be avoided in a mating process of the gas pipeline. Therefore, the embodiments of the present disclosure can solve the problem that contact can be easily caused in the mating process of the gas pipeline of the existing semiconductor process equipment. In addition, the present disclosure can avoid the technical solution in the prior art that compression of the sealing ring 230 is achieved by a compression force of a spring in the connecting device, so that the connecting device 300 has better reliability.

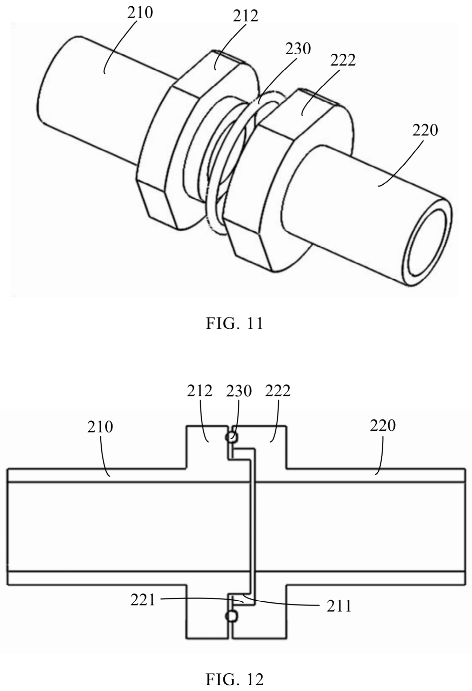

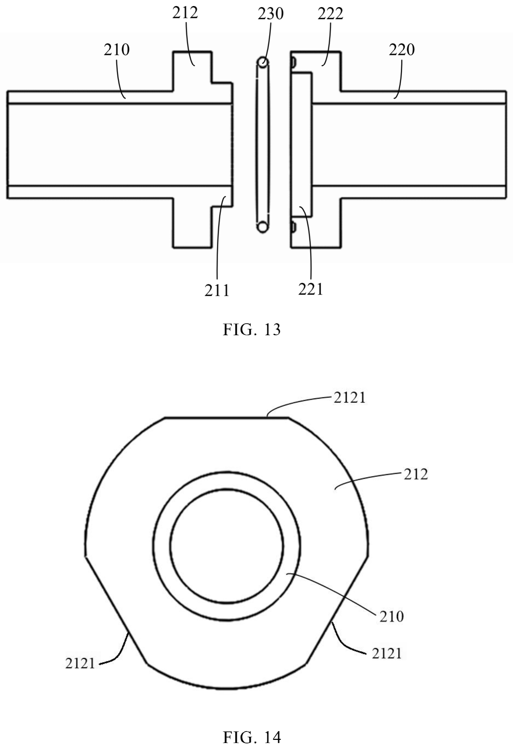

Referring to FIG. 12 and FIG. 13, in some embodiments, one of a surface of the first connector 210 facing the second connector 220 and a surface of the second connector 220 facing the first connector 210 is provided with a matching protrusion 211, the other of the surface of the first connector 210 facing the second connector 220 and the surface of the second connector 220 facing the first connector 210 is provided with a matching groove 221, and at least part of the matching protrusion 211 is located in the matching groove 221, which can not only improve the sealing performance between the first connector 210 and the second connector 220, but also avoid incorrect mating of the first connector 210 and the second connector 220 and produce a fool-proofing effect. For example, in FIG. 12 and FIG. 13, the surface of the first connector 210 facing the second connector 220 is provided with the matching protrusion 211, and the surface of the second connector 220 facing the first connector 210 is provided with the matching groove 221.

In addition, the arrangement of the matching protrusion 211 and the matching groove 221 can extend a flow path of a gas overflowing from the connection between the first connector 210 and the second connector 220, so as to prolong the time for the gas to reach the sealing ring 230 and allow adequate heat dissipation of the gas, thereby protecting the sealing ring 230. Moreover, a gap is provided between a surface of the matching protrusion 211 and an inner wall of the matching groove 221, in which case the gap can provide a moving space for the matching protrusion 211 and the matching groove 221 in the mating process of the first connector 210 and the second connector 220 to avoid the contact between the first connector 210 and the second connector 220. Certainly, the surfaces of the first connector 210 and the second connector 220 which face each other may also be flat surfaces, and the sealing ring 230 may be disposed close to an edge of the flat surface.

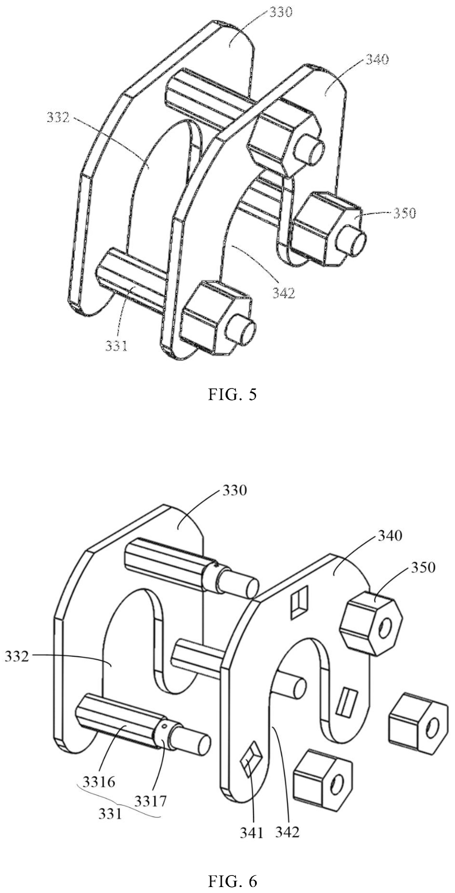

Referring to FIG. 5 to FIG. 8, in some embodiments, each of the number of the positioning column 331 and the number of the positioning hole 341 may be one, in which case the positioning hole 341 may be made relatively large to ensure a positioning effect, that is, relatively large cross-sectional area is adopted, the positioning hole 341 may be set as an arc-shaped hole, and the positioning column 331 is matched with the positioning hole 341; or, each of the number of the positioning columns 331 and the number of the positioning holes 341 is at least two, at least two positioning columns 331 are arranged apart along a circumferential direction of the first connector 210, and the positioning columns 331 are matched with the positioning holes 341 in a one-to-one correspondence, in which case cross-sectional area of each positioning column 331 and cross-sectional area of each positioning hole 341 may be set smaller, and the positioning holes 341 formed in the second clamping member 340 may be arranged in a scattered manner, so that an acting force applied to the second clamping member 340 can be scattered, which facilitates protection for the second clamping member 340. Meanwhile, relative positions of the first connector 210 and the second connector 220 can be limited reliably, so that the central axis of the first connector 210 can accurately coincide with the central axis of the second connector 220.

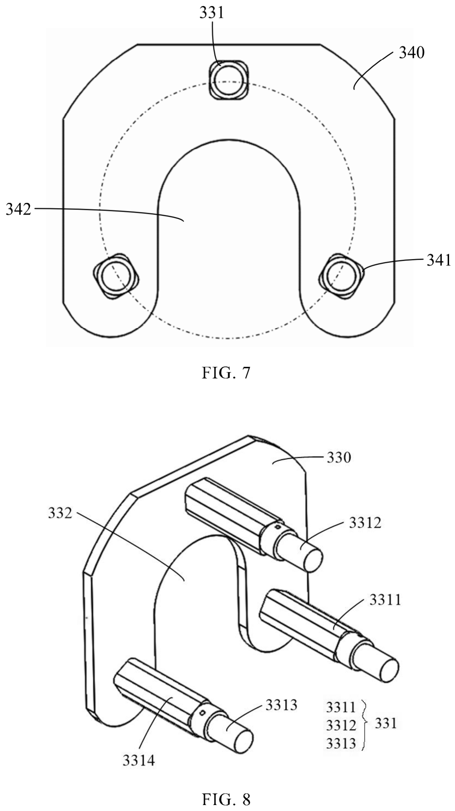

Further, in some embodiments, the at least two positioning columns 331 include a first positioning column 3311, a second positioning column 3312, and a third positioning column 3313, two of which are disposed opposite to each other, that is, every two of the first positioning column 3311, the second positioning column 3312, and the third positioning column 3313 are disposed opposite to each other. Specifically, the first positioning column 3311 is disposed opposite to the third positioning column 3313, the first positioning column 3311 is disposed opposite to the second positioning column 3312, the second positioning column 3312 is disposed opposite to the third positioning column 3313, a first distance between the second positioning column 3312 and the first positioning column 3311 is equal to a second distance between the second positioning column 3312 and the third positioning column 3313, in which case the first positioning column 3311, the second positioning column 3312, and the third positioning column 3313 are distributed in an isosceles triangle or an equilateral triangle, which facilitates improvement in positioning stability of the first clamping member 330. Certainly, the first distance may not be equal to the second distance. In some examples, the first clamping member 330 and the second clamping member 340 are both U-shaped structures (e.g., U-shaped plates), in which case, as shown in FIG. 8, the first positioning column 3311 and the third positioning column 3313 are respectively located at two ends of the U-shaped structure, and the second positioning column 3312 is located at a bent portion of the U-shaped structure. In this way, due to the shape of the U-shaped structure, the first positioning column 3311, the second positioning column 3312, and the third positioning column 3313 can be uniformly distributed on the U-shaped structure, so that an acting force applied to the U-shaped structure can be uniform, which facilitates protection for the U-shaped structure. Meanwhile, the relative positions of the first connector 210 and the second connector 220 can be limited more reliably, so that the central axis of the first connector 210 can coincide with the central axis of the second connector 220 more accurately.

In some embodiments, the positioning column 331 is in contact with the first connector 210 and the second connector 220 to achieve positioning fit. Specifically, the positioning column 331 may be a positioning cylinder, in which case the positioning column 331 is in linear contact with the first connector 210 and the second connector 220; or, in other embodiments, the positioning column 331 is provided with a third positioning plane 3314, which is respectively in positioning fit with a first positioning plane 2121 of a first flange part 212 of the first connector 210 and a second positioning plane 2221 of a second flange part 222 of the second connector 220 along the circumferential direction of the first connector 210, and the positioning fit may be direct positioning fit or indirect positioning fit through other components (such as a protection sleeve described below). In this case, the positioning column 331 is in surface contact with both the first connector 210 and the second connector 220, which facilitates improvement in positioning stability of the positioning column 331. Certainly, the first positioning plane 2121 of the first flange part 212 and the second positioning plane 2221 of the second flange part 222 may be concave surfaces, in which case the positioning column 331 is provided with a convex positioning surface, but the manufacture of the positioning column 331, the first flange part 212, and the second flange part 222 is not easy in this case and is more difficult than that in a case where the third positioning plane 3314, the first positioning plane 2121, and the second positioning plane 2221 are set as flat surfaces as described above.

In addition, as shown in FIG. 14, in a case where the first positioning column 3311, the second positioning column 3312, and the third positioning column 3313 are distributed in an isosceles triangle or an equilateral triangle, the number of the first positioning planes 2121 is three, and the three first positioning planes 2121 are in one-to-one correspondence with the first positioning column 3311, the second positioning column 3312, and the third positioning column 3313 along the circumferential direction of the first connector 210.

There are various ways of connecting the first clamping member 330 to the second clamping member 340 to clamp the first connector 210 and the second connector 220. In some embodiments, the connecting device further includes a connecting assembly 350, and one end of the positioning column 331 passes through the positioning hole 341 to be connected to the connecting assembly 350, so as to enable the first clamping member 330 and the second clamping member 340 to clamp the first connector 210 and the second connector 220.

In some embodiments, the connecting assembly 350 may be directly sleeved on the positioning column 331, and the connecting assembly 350 and the positioning column 331 are connected to each other by friction or by threads; in some other embodiments, the connecting assembly 350 is sleeved on the positioning column 331, and is capable of rotating relative to the positioning column 331 to a position where the connecting assembly 350 is in positioning fit with the positioning column 331 along the circumferential direction of the first connector 210, so as to enable the first connector 210 to be in sealing fit with the second connector 220. In this case, the specific position where the connecting assembly 350 is in positioning fit with the positioning column 331 along the circumferential direction of the first connector 210 may be determined in advance based on the amount of compression of the sealing ring 230 disposed between the first connector 210 and the second connector 220, so as to avoid frequent measurement of a distance between the first connector 210 and the second connector 220 during the rotation of the connecting assembly 350 relative to the positioning column 331, thereby improving assembly efficiency of the first connector 210 and the second connector 220.

In some embodiments, in the embodiments where each of the number of the positioning columns 331 and the number of the positioning holes 341 is at least two and the at least two positioning columns 331 are arranged apart along the circumferential direction of the first connector 210, the connecting assemblies 350 and the positioning columns 331 are disposed in a one-to-one correspondence, that is, a plurality of connecting assemblies 350 are sleeved on the positioning columns 331 in a one-to-one correspondence, and each connecting assembly 350 is capable of rotating relatively to the corresponding positioning column 331 to a position where the connecting assembly 350 is in positioning fit with the corresponding positioning column 331 along the circumferential direction of the first connector 210 , so as to enable the first connector 210 to be in sealing fit with the second connector 220. In this case, the positions where the connecting assemblies 350 are in positioning fit with the positioning columns 331 are at a same height, so that the second clamping member 340 and the second connector 220 can be prevented from tilting, and the position of each connecting assembly 350 does not need to be manually adjusted, which facilitates improvement in assembly efficiency of the connecting device 300.

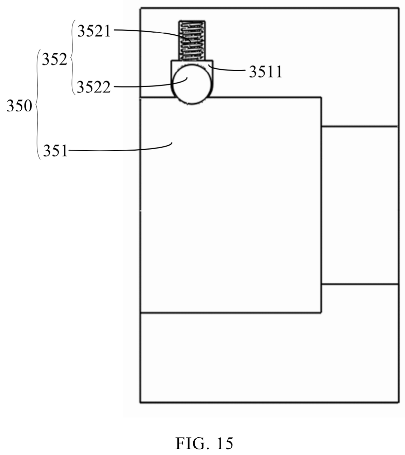

Referring to FIG. 15, in yet other embodiments, the connecting assembly 350 includes a connecting sleeve 351 and a locking member 352, and the connecting sleeve 351 is sleeved on the positioning column 331; in some embodiments, the locking member 352 may be a deformable part directly disposed on an inner wall of the connecting sleeve 351, a positioning groove 3315 is provided on a peripheral surface of the positioning column 331, the deformable part is in positioning fit with the positioning groove 3315 along the circumferential direction of the first connector 210, and when the connecting assembly 350 is subjected to a large acting force, the deformable part can be easily detached from the positioning groove 3315, that is, positioning stability of the connecting assembly 350 and the positioning groove 3315 is poor. Moreover, the deformable part can be easily damaged in a process of sleeving the connecting sleeve 351 on the positioning column 331. In view of this, in some embodiments, one of the inner wall of the connecting sleeve 351 and the peripheral surface of the positioning column 331 is provided with a mounting groove 3511, the locking member 352 is movably disposed in the mounting groove 3511, and the other of the inner wall of the connecting sleeve 351 and the peripheral surface of the positioning column 331 is provided with the positioning groove 3315. The locking member 352 is retracted into the mounting groove 3511 in the process of sleeving the connecting sleeve 351 on the positioning column 331 along the positioning column 331, and when the connecting sleeve 351 reaches a position enabling the locking member 352 to correspond to the positioning groove 3315, part of the locking member 352 is extended out of an opening of the mounting groove 3511 and is in positioning fit with the positioning groove 3315 along the circumferential direction of the first connector 210. For example, the inner wall of the connecting sleeve 351 is provided with the mounting groove 3511, the locking member 352 is movably disposed in the mounting groove 3511, and the locking member 352 is in positioning fit with the positioning groove 3315 along the circumferential direction of the first connector 210. In this case, at least part of the locking member 352 may be a rigid structure, which ensures good stability after the locking member 352 is in positioning fit with the positioning groove 3315; moreover, the locking member 352 may be located in the mounting groove 3511 in the process of sleeving the connecting sleeve 351 on the positioning column 331, so that the locking member 352 is prevented from being damaged.

In some embodiments, the connecting sleeve 351 may be a hexagon nut. Certainly, the connecting sleeve 351 may also be other structures, which is not particularly limited herein.

Further, in some embodiments, the locking member 352 includes an elastic driving portion 3521 and a positioning portion 3522 connected to each other, the elastic driving portion 3521 is capable of driving part of the positioning portion 3522 to be extended out of the opening of the mounting groove 3511, so as to enable the positioning portion 3522 to be in positioning fit with the positioning groove 3315, at this time, the elastic driving portion 3521 always acts on the positioning portion 3522 with an elastic force of the elastic driving portion 3521, that is, the elastic driving portion 3521 is always in a compressed state, so as to improve positioning stability of the positioning portion 3522; in addition, the elastic driving portion 3521 may be a spring, and has the advantages of simple structure, small occupied space, and low cost. Certainly, the elastic driving portion 3521 may be replaced with a driving member such as a miniature cylinder or a hydraulic cylinder.

In some embodiments, the positioning portion 3522 may be a positioning block, and when the positioning block is detached from the positioning groove 3315, an acting force applied to the positioning block by the connecting sleeve 351 can easily damage the positioning block. Therefore, in some embodiments, an end of the positioning portion 3522 away from the elastic driving portion 3521 may be a semicircular structure or a conical structure, and performs a guiding function to make it easy for the positioning block to be detached from the positioning groove 3315. Further, in some embodiments, the positioning portion 3522 is a positioning ball, curvature of each part of the positioning ball is the same, the positioning ball is capable of rotating relative to the elastic driving portion 3521, and the positioning ball can move and rotate simultaneously while being detached from the positioning groove 3315, which further improves smoothness of the detachment of the positioning block from the positioning groove 3315.

In some embodiments, the mounting groove 3511 includes a first accommodating cavity and a second accommodating cavity communicated with each other, the elastic driving portion 3521 is disposed in the first accommodating cavity, the positioning portion 3522 is disposed in the second accommodating cavity, one end of the second accommodating cavity away from the first accommodating cavity is provided with a limiting sidewall, the opening is formed on the limiting sidewall, the elastic driving portion 3521 is capable of driving the positioning portion 3522 to be pressed against the limiting sidewall, the limiting sidewall is configured to limit part of the positioning portion 3522 within the mounting groove 3511, and the remaining part of the positioning portion 3522 is located outside the mounting groove 3511, that is, the limiting sidewall can limit the positioning portion 3522, such that only part of the positioning portion can be extended out of the mounting groove 3511, and the positioning portion 3522 can be prevented from being detached from the mounting groove 3511, so as to improve stability of the positioning fit between the positioning portion 3522 and the positioning groove 3315.

Part of the positioning portion 3522 is attached to the limiting sidewall, that is, the positioning portion 3522 is matched with the limiting sidewall. Further, in some embodiments, the positioning portion 3522 is a positioning ball, the limiting sidewall may be an arc-shaped structure capable of being attached to part of the positioning ball, and cross-sectional area of the limiting sidewall gradually decreases in an extension direction from the first accommodating cavity to the second accommodating cavity. The limiting sidewall with such structure can increase contact area between the positioning portion 3522 and the connecting sleeve 351, so as to improve stability of the positioning portion 3522; in addition, a diameter of the opening on the limiting sidewall with such structure is smaller than a diameter of the positioning portion 3522, which can prevent the positioning portion 3522 from being detached from the mounting groove 3511.

In still other embodiments, the positioning column 331 includes a positioning section 3316 and a connecting section 3317 connected to each other, the second clamping member 340 is sleeved on the positioning section 3316 through the positioning hole 341, and the positioning section 3316 is in positioning fit with the positioning hole 341 along the circumferential direction of the first connector 210. In some embodiments, a cross-sectional shape of the positioning section 3316 may be circular, in which case curvature of each part of a circumferential surface of the positioning section 3316 is the same, and the first clamping member 330 and the second clamping member 340 are prone to deviate. In view of this, in other embodiments, the cross-sectional shape of the positioning section 3316 is polygonal, and the positioning hole 341 is a polygonal hole matched with the positioning section 3316 in shape, that is, the cross-sectional shape of the positioning section 3316 may be the same as a shape of the positioning hole 341. In this case, after the positioning section 3316 is positioning fit with the positioning hole 341, an outline of an orthographic projection of the first clamping member 330 coincides with an outline of an orthographic projection of the second clamping member 340 in an axial direction of the first connector 210, so that positioning accuracy of the first clamping member 330 and the second clamping member 340 is improved. When the cross-sectional shape of the positioning section 3316 is polygonal, a peripheral surface of the positioning section 3316 includes a plurality of planes connected in sequence, and the adjacent planes may be smoothly connected by an arc surface, so as not to scratch other components. Certainly, the adjacent planes described here may also be directly connected.

In some embodiments, the cross-sectional shape of the positioning section 3316 may be triangular or rectangular, which is not particularly limited herein.

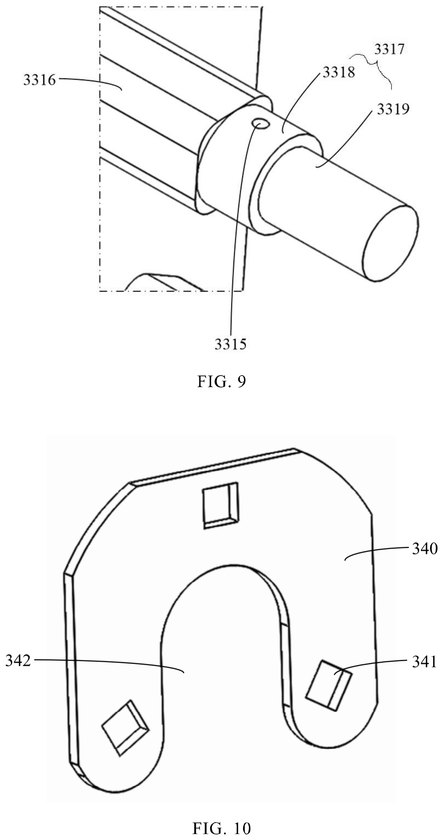

Referring to FIG. 9, in some other embodiments, the positioning column 331 includes a smooth section 3318 and a threaded connection section 3319 connected to each other, and a diameter of the smooth section 3318 is greater than that of the threaded connection section 3319, so that a positioning end face is formed between the smooth section 3318 and the threaded connection section 3319, that is, a step is formed at a connection between the smooth section 3318 and the threaded connection section 3319, the step forms the positioning end face, and the connecting assembly 350 is in thread fit with the threaded connection section 3319 and in positioning fit with the smooth section 3318, which improves connection firmness of the connecting assembly 350. The connecting assembly 350 may be in positioning fit with the positioning end face in an axial direction of positioning column 331, so that the connecting assembly 350 is prevented from further moving relative to the positioning column 331. Certainly, in the above technical solution, the connecting assembly is in thread fit with the threaded connection section 3319 in the absence of the smooth section 3318.

In some embodiments, in the embodiments where the positioning column 331 includes the positioning section 3316 and the connecting section 3317 connected to each other, the smooth section 3318 and the threaded connection section 3319 may form the connecting section 3317. Certainly, in the above technical solution, only the connecting section 3317 may be provided without the positioning section 3316, and the connecting section 3317 may be formed by the smooth section 3318 and the threaded connection section 3319. In some embodiments, the positioning section 3316, the smooth section 3318, and the threaded connection section 3319 may be connected in sequence by welding, machining, or the like.

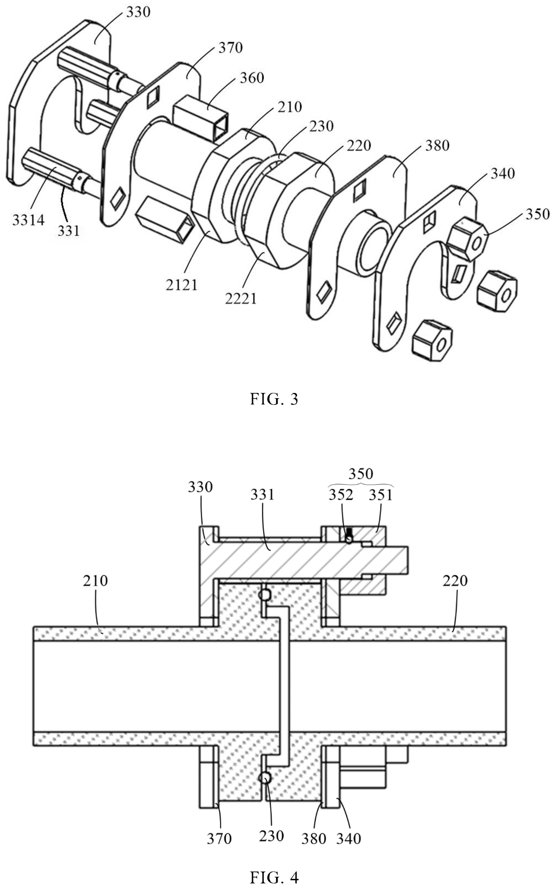

Referring to FIG. 3, in still other embodiments, the connecting device 300 further includes a protection sleeve 360, which is sleeved on the positioning column 331, is located between the first clamping member 330 and the second clamping member 340, and is disposed in one-to-one correspondence with the positioning column 331. In this technical solution, the arrangement of the protection sleeve 360 can prevent the positioning column 331 from being in direct contact with the first connector 210 and the second connector 220, so as to protect the first connector 210 and the second connector 220. In some embodiments, the protection sleeve 360 may be a resin sleeve, which has the characteristics of good flexibility, corrosion resistance, high and low temperature resistance, aging resistance, and long service life. Certainly, the protection sleeve 360 may be other structures, which is not particularly limited herein.

In some embodiments, in the embodiments where the number of the positioning columns 331 is at least two, the protection sleeves 360 are disposed in one-to-one correspondence with the positioning columns 331, so as to protect the first connector 210 and the second connector 220. Further, the protection sleeves 360 may adopt prism structures, so that the third positioning planes 3314 of the positioning columns 331 are respectively in positioning fit with the first positioning planes 2121 of the first flange part 212 of the first connector 210 and the second positioning planes 2221 of the second flange part 222 of the second connector 220 along the circumferential direction of the first connector 210 through the protection sleeves 360.

In still other embodiments, the connecting device 300 further includes a first buffer pad 370 and a second buffer pad 380, the first buffer pad 370 is disposed between the first clamping member 330 and the first flange part 212 of the first connector 210, and the second buffer pad 380 is disposed between the second clamping member 340 and the second flange part 222 of the second connector 220. In this technical solution, the first buffer pad 370 and the second buffer pad 380 can not only play a role of buffering, but also prevent the first clamping member 330 from being in direct contact with the first connector 210 and prevent the second clamping member 340 from being in direct contact with the second connector 220, so as to protect the first connector 210 and the second connector 220. In some embodiments, each of the first buffer pad 370 and the second buffer pad 380 may be made of a resin material, which has the characteristics of good flexibility, corrosion resistance, high and low temperature resistance, aging resistance, and long service life. Certainly, the first buffer pad 370 and the second buffer pad 380 may be made of other materials, which is not particularly limited herein.

In some embodiments, each of the first clamping member 330 and the second clamping member 340 may adopt a split structure, and all parts of the split structure are spliced to form an annular structure (e.g., an annular plate); or, the first clamping member 330 and the second clamping member 340 are U-shaped structures (e.g., U-shaped plates), and the first clamping member 330 is provided with a first avoidance opening 332 for avoiding the first connector 210, so as to enable the first clamping member 330 to be sleeved on the first connector 210 through the first avoidance opening 332; and the second clamping member 340 is provided with a second avoidance opening 342 for avoiding the second connector 220, so as to enable the second clamping member 340 to be sleeved on the second connector 220 through the second avoidance opening 342. Further, in some embodiments, a peripheral surface of each of the first clamping member 330 and the second clamping member 340 is entirely curved or includes curved surfaces and flat surfaces smoothly connected to each other, so as not to scratch other structures during installation.

A mating process of the gas pipeline of the semiconductor process equipment provided in the present disclosure is as follows: firstly, the first buffer pad 370 is mounted to the first clamping member 330 and is attached to the first clamping member 330; then, the protection sleeve 360 is sleeved on the positioning column 331 of the first clamping member 330; then, the first clamping member 330 is mounted to the first connector 210, and the first positioning plane 2121 of the first flange part 212 of the first connector 210 is matched with the protection sleeve 360; then, the matching groove 221 of the second connector 220 which has the sealing ring 230 mounted thereto is mounted to the matching protrusion 211 of the first connector 210 to achieve mating of the second connector 220 and the first connector 210, and during the mounting process, the first connector 210 is prevented from colliding with the second connector 220 due to the positioning by the positioning column 331 and the protective buffering by the protection sleeve 360; then, the second buffer pad 380 and the second clamping member 340 are sequentially mounted; and finally, the connecting assembly 350 is mounted to the connecting section 3317 of the positioning column 331 to insert the positioning portion 3522 of the connecting assembly 350 into the positioning groove 3315 of the positioning column 331 to realize the positioning fit, and the position for the positioning fit satisfies the amount of compression of the sealing ring 230, thereby achieving assembly of the connecting device 300.

The embodiments of the present disclosure are described above with reference to the drawings, but the present disclosure is not limited to the above specific implementations which are just for illustration rather than for limitation. Enlightened by the present disclosure, those of ordinary skill in the art can make many variations without departing from the spirit of the present disclosure and the scope of the claims, and all those variations fall within the scope of the present disclosure.

## Claims

1. A semiconductor process equipment, comprising a process chamber, a first connector, a second connector, and a connecting device, wherein the first connector is connected to the process chamber,
the connecting device comprises a first clamping member and a second clamping member, and the first clamping member and the second clamping member are configured to clamp the first connector and the second connector to enable the first connector to be in sealing fit with the second connector to form a gas pipeline; and
the first clamping member is sleeved on the first connector, the second clamping member is sleeved on the second connector, one of the first clamping member and the second clamping member is provided with a positioning column, the other of the first clamping member and the second clamping member is provided with a positioning hole, the positioning column is in positioning fit with the positioning hole to make a central axis of the first connector coincide with a central axis of the second connector, and a gap is provided between the first connector and the second connector.

2. The semiconductor process equipment of claim 1, wherein one of a surface of the first connector facing the second connector and a surface of the second connector facing the first connector is provided with a matching protrusion, the other of the surface of the first connector facing the second connector and the surface of the second connector facing the first connector is provided with a matching groove, at least part of the matching protrusion is located in the matching groove, and a gap is provided between a surface of the matching protrusion and an inner wall of the matching groove.

3. The semiconductor process equipment of claim 1, wherein each of a number of positioning columns and a number of positioning holes is at least two, at least two positioning columns are arranged apart along a circumferential direction of the first connector, and the positioning columns are matched with positioning holes in a one-to-one correspondence.

4. The semiconductor process equipment of claim 3, wherein the at least two positioning columns comprise a first positioning column, a second positioning column, and a third positioning column, and every two of the first positioning column, the second positioning column, and the third positioning column are disposed opposite to each other; and a first distance between the second positioning column and the first positioning column is equal to a second distance between the second positioning column and the third positioning column;
wherein both the first clamping member and the second clamping member are U-shaped structures, the first positioning column and the third positioning column are respectively located at two ends of a U-shaped structure, and the second positioning column is located at a bent position of the U-shaped structure.

5. The semiconductor process equipment of claim 1, wherein the positioning column is provided with a third positioning plane, which is respectively in positioning fit with a first positioning plane of a first flange part of the first connector and a second positioning plane of a second flange part of the second connector along a circumferential direction of the first connector.

6. The semiconductor process equipment of any one of claims 1 to 5, wherein the connecting device further comprises a connecting assembly, and one end of the positioning column passes through the positioning hole to be connected to the connecting assembly to enable the first clamping member and the second clamping member to clamp the first connector and the second connector.

7. The semiconductor process equipment of claim 6, wherein the connecting assembly is sleeved on the positioning column and is capable of rotating relative to the positioning column to a position where the connecting assembly is in positioning fit with the positioning column along a circumferential direction of the first connector to enable the first connector to be in sealing fit with the second connector.

8. The semiconductor process equipment of claim 6, wherein each of a number of positioning columns and a number of positioning holes is at least two, at least two positioning columns are arranged apart along a circumferential direction of the first connector, and the positioning columns are matched with positioning holes in a one-to-one correspondence; and
a plurality of connecting assemblies are provided and are sleeved on the positioning columns in a one-to-one correspondence, each connecting assembly is capable of rotating relatively to a corresponding positioning column to a position where the connecting assembly is in positioning fit with the corresponding positioning column along the circumferential direction of the first connector, and positions where the connecting assemblies are in positioning fit with the corresponding positioning columns are at a same height.

9. The semiconductor process equipment of claim 6, wherein the connecting assembly comprises a connecting sleeve and a locking member, and the connecting sleeve is sleeved on the positioning column; and
one of an inner wall of the connecting sleeve and a peripheral surface of the positioning column is provided with a mounting groove, the locking member is movably disposed in the mounting groove, and the other of the inner wall of the connecting sleeve and the peripheral surface of the positioning column is provided with a positioning groove; and the locking member is retracted into the mounting groove in a process of sleeving the connecting sleeve on the positioning column along the positioning column, and when the connecting sleeve reaches a position enabling the locking member to correspond to the positioning groove, part of the locking member is extended out of an opening of the mounting groove and is in positioning fit with the positioning groove along a circumferential direction of the first connector.

10. The semiconductor process equipment of claim 9, wherein the locking member comprises an elastic driving portion and a positioning portion connected to each other, and the elastic driving portion is capable of driving part of the positioning portion to be extended out of the opening of the mounting groove to enable the positioning portion to be in positioning fit with the positioning groove.

11. The semiconductor process equipment of claim 10, wherein the mounting groove comprises a first accommodating cavity and a second accommodating cavity communicated with each other, the elastic driving portion is disposed in the first accommodating cavity, the positioning portion is disposed in the second accommodating cavity, one end of the second accommodating cavity away from the first accommodating cavity is provided with a limiting sidewall, the opening is formed on the limiting sidewall, the elastic driving portion is capable of driving the positioning portion to be pressed against the limiting sidewall, and part of the positioning portion is attached to the limiting sidewall; and the limiting sidewall is configured to limit part of the positioning portion within the mounting groove.

12. The semiconductor process equipment of claim 11, wherein the positioning portion is a positioning ball; and the limiting sidewall is an arc-shaped structure capable of being attached to part of the positioning ball, and cross-sectional area of the limiting sidewall gradually decreases in an extension direction from the first accommodating cavity to the second accommodating cavity.

13. The semiconductor process equipment of claim 6, wherein the positioning column comprises a positioning section and a connecting section connected to each other, the second clamping member is sleeved on the positioning section through the positioning hole, the positioning section is in positioning fit with the positioning hole along a circumferential direction of the first connector, a cross-sectional shape of the positioning section is polygonal, the positioning hole is a polygonal hole matched with the positioning section in shape, and the connecting assembly is connected to the connecting section.

14. The semiconductor process equipment of claim 6, wherein the positioning column comprises a smooth section and a threaded connection section connected to each other, a diameter of the smooth section is greater than a diameter of the threaded connection section to form a positioning end face between the smooth section and the threaded connection section, the connecting assembly is in thread fit with the threaded connection section and in positioning fit with the smooth section, and the connecting assembly is in positioning fit with the positioning end face in an axial direction of positioning column.

15. The semiconductor process equipment of any one of claims 1 to 5, wherein the connecting device further comprises a protection sleeve, which is sleeved on the positioning column, is located between the first clamping member and the second clamping member, and is disposed in one-to-one correspondence with the positioning column.

16. The semiconductor process equipment of any one of claims 1 to 5, wherein the connecting device further comprises a first buffer pad and a second buffer pad, the first buffer pad is disposed between the first clamping member and a first flange part of the first connector, and the second buffer pad is disposed between the second clamping member and a second flange part of the second connector.
